# EUROPÄISCHE PATENTANMELDUNG

(11) **EP 1 093 970 A2**
(43) Veröffentlichungstag der Anmeldung: **25.04.2001**
(21) Anmeldenummer: 00120278.7
(22) Anmeldetag: 28.09.2000
(51) Int. Cl.: B60R 1/072

(54) **Stellenantrieb zum Verstellen eines Stellglieds in zumindest zwei Freiheitsgraden**

(30) Priorität: 23.10.1999 DE 19951077
(71) Anmelder: Bühler Motor GmbH, 90459 Nürnberg (DE)
(72) Erfinder: Guttenberger, Richard, 91171 Greding (DE)

(57) **Zusammenfassung**

Die Erfindung betrifft einen Stellantrieb zum Verstellen eines Stellglieds in zumindest zwei Freiheitsgraden, mit mindestens einem Antriebsmotor, dessen Ausgangswelle getrieblich mit einem das Stellglied antreibenden Untersetzungsgetriebe verbunden ist, zwei, die Ist-Stellung des Stellglieds erfassenden, auf einer Leiterplatte angeordneten Potentiometern mit Widerstandsbahnen und Schleifern und einem Antriebsgehäuse. Aufgabe der Erfindung ist es daher einen gattungsgemäßen Stellantrieb zu schaffen, der zumindest teilweise modular aufgebaut ist, bei dem die Funktion der Potentiometer bereits vor dem Einbau in den Stellantrieb prüfbar ist, der aus möglichst wenigen Bauteilen besteht, möglichst einfach montierbar ist und dessen Potentiometer auf einfache Weise spielfrei in Bezug auf das Stellglied und/oder das Untersetzungsgetriebe anordbar ist. Diese Aufgabe wird erfindungsgemäß dadurch gelöst, dass die Leiterplatte (10) aus einem zumindest teilweise in Kunststoffmaterial eingebetteten Leitblech (11) besteht, das die Enden der einzelnen Widerstandsbahnen elektrisch mit Kontaktstellen verbindet, die Widerstandsbahnen zwischen ihren Enden vom Kunststoffmaterial getragen werden, die Schleifer auf Schleiferträgern befestigt sind, die in Form von Zahnrädern, Reibrädern oder Kurbelscheiben ausgebildet, drehbar in der Leiterplatte (10) gelagert und getrieblich mit dem Untersetzungsgetriebe (5) und/oder dem Stellglied verbunden sind und daß die Leiterplatte (10) an zumindest einer Stelle abgewinkelt ist, wodurch die Widerstandsbahnen (7) der beiden Potentiometer (6) in unterschiedlichen Ebenen angeordnet sind und die Leiterplatte (10) mit den Potentiometern (6) und den Kontaktstellen eine Baugruppe bilden, wobei die beiden Potentiometer (6) der Baugruppe (10) zueinander nicht starr angeordnet sind.

## Beschreibung

Die Erfindung betrifft einen Stellantrieb zum Verstellen eines Stellglieds in zumindest zwei Freiheitsgraden, mit mindestens einem Antriebsmotor, dessen Ausgangswelle getrieblich mit einem das Stellglied antreibenden Untersetzungsgetriebe verbunden ist, zwei, die Ist-Stellung des Stellglieds erfassenden, auf einer Leiterplatte angeordneten Potentiometern mit Widerstandsbahnen und Schleifern und einem Antriebsgehäuse.

Aus der DE-PS 197 24 725 ist eine Vorrichtung zum elektrischen Einstellen des Innen- oder Außenspiegels eines Kraftfahrzeugs bakannt, wobei als Verstellelemente zwei in einem Antriebsgehäuse gehaltene Elektro-Kleinstmotoren vorgesehen sind, die über eine mit mindestens je einer Leiter- und Widerstandsbahn versehene Leiterplatte elektrisch beaufschlagt sind. Bei dem bekannten Antrieb sind die Schleifer getrennt von der Leiterplatte auf anderen Bauteilen montiert. Dadurch kann die Funktion der Potentiometer erst im montierten Zustand geprüft werden.

Aufgabe der Erfindung ist es einen Stellantrieb zum Verstellen eines Stellglieds in zumindest zwei Freiheitsgraden zu schaffen, der zumindest teilweise modular aufgebaut ist, bei dem die Funktion der Potentiometer bereits vor dem Einbau in den Stellantrieb prüfbar ist, der aus möglichst wenigen Bauteilen besteht, möglichst einfach montierbar ist und dessen Potentiometer auf einfache Weise spietfrei in Bezug auf das Stellglied und/oder das Untersetzungsgetriebe anordbar ist.

Diese Aufgabe wird erfindungsgemäß dadurch gelöst, dass die Leiterplatte aus einem zumindest teilweise in Kunststoffmaterial eingebetteten Leitblech besteht, das die Enden der einzelnen Widerstandsbahnen elektrisch mit Kontaktstellen verbindet, die Widerstandsbahnen zwischen ihren Enden vom Kunststoffmaterial getragen werden, die Schleifer auf Schleiferträgem befestigt sind, die in Form von Zahnrädern, Reibrädern oder Kurbelscheiben ausgebildet, drehbar in der Leiterplatte gelagert und getrieblich mit dem Untersetzungsgetriebe und/oder dem Stellglied verbunden sind und daß die Leiterplatte an zumindest einer Stelle abgewinkelt ist, wodurch die Widerstandsbahnen der beiden Potentiometer in unterschiedlichen Ebenen angeordnet sind und die Leiterplatte mit den Potentiometern und den Kontaktstellen eine Baugruppe bilden, wobei die beiden Potentiometer der Baugruppe zueinander nicht starr angeordnet sind. Durch die Ausbildung der Leiterplatte als ein in Kunststoffmaterial eingebettetes Leitblech ist eine nahezu beliebige Formgebung der Leiterplatte möglich, so dass sie auch an komplizierte Einbaubedingungen angepasst werden kann. Die Kontaktstellen erleichtern die Kontaktierung und den Einbau der Leiterplatte. Die Montage der Schleiferträger auf der Leiterplatte ermöglicht eine Baugruppe mit kompletten Potentiometern. Dadurch kann die Baugruppe gesondert gefertigt und ihre Funktion bereits vor dem Einbau in den Stellantrieb überprüft werden. Durch die Ausbildung der Schleiferträger als Zahnräder, Reibräder oder Kurbelscheiben ist eine mechanische Kopplung der Potentiometer an das Untersetzungsgetriebe und/oder das Stellglied möglich. Die Abwinkelung der Leiterplatte erlaubt es die Einbaulage der Potentiometer in unterschiedlichen Ebenen vorzunehmen, wobei dennoch die für die Herstellung der Potentiometer günstigere Anordnung in einer Ebene vor der Abwinkelung möglich ist. Da die beiden Potentiometer nicht starr zueinander angeordnet sind ist ein Toleranzausgleich und daher Spielausgleich zwischen den Potentiometern und dem Untersetzungsgetriebe und/oder dem Stellglied möglich.

Weitere vorteilhafte Ausführungsformen der Erfindung werden in den Unteransprüchen dargestellt.

Zweckmäßigerweise ist das Kunststoffmaterial der Leiterplatte mit Befestigungsmitteln zur Befestigung der Leiterplatte in dem Antriebsgehäuse einstückig. Dadurch werden zusätzliche Teile für die Befestigung eingespart. Eine einfache Montage wird dabei Erreicht, wenn die Leiterplatte im Antriebsgehäuse einrastbar ausgebildet ist.

Um Spielfreiheit zwischen dem Schleiferträger und dem Untersetzungsgetriebe und/oder dem Stellglied zu erreichen ist es von Vorteil, die Leiterplatte im Antriebsgehäuse begrenzt kippbar auszuführen. Die Zuordnung zwischen dem Antriebsgehäuse, der Leiterplatte und dem Untersetzungsgetriebe ist einfacher dadurch herzustellen und aufrecht zu erhalten, wenn die Leiterplatte im Antriebsgehäuse geführt ist. Vorzugsweise sind Führungen vorgesehen, die rechtwinklig zur Achse von Getriebeelementen angeordnet sind, die unmittelbar mit den Schleiferträgern der Potentiometer gekoppelt sind.

Eine besonders vorteilhafte Weiterbildung der Erfindung besteht dann, das Leitblech mit federnden Bereichen einstückig auszuführen, weil dadurch die Spielfreiheit zwischen dem Schleiferträger und einem Getriebeelement herstellbar ist. Bevorzugt ist die Leiterplatte dabei in drei Bereiche unterteilt, in einen Kontaktbereich und in zwei Potentiometerbereiche, wobei der Kontaktbereich jeweils über mehrere Leiterbahnen des Leitblechs einerseits mit dem einen Potentiometerbereich und andererseits mit dem anderen Potentiometerbereich verbunden ist und die Leiterbahnen die federnden Bereiche bilden. Diese Ausführung ist besonders Platzsparend, zudem ist es möglich durch die Gestaltung der Leiterbahnen die Federkraft einzustellen. Vorzugsweise wird die Leiterplatte so gebogen, dass durch den Einbau in das Antriebsgehäuse eine Vorspannung erzeugt wird.

Es ist sinnvoll gerade die Potentiometerbereiche in den Führungen zu führen, da sie nahe der Ebene der Schleiferträger liegen. Weiter ist an jedem Potentiometerbereich je ein Gelenkteil vorgesehen, in das ein komplementäres Gelenkteil des Gehäuses einschnappbar ist. Dabei ist es wichtig, daß mindestens eine mögliche Schwenkachse, insbesondere, wenn es sich um ein Kugelgelenk und nicht um ein zylindrisches Gelenk handelt, parallel zur Drehachse des korrespondierenden Getriebeelements verläuft, um eine begrenzte Schwenkbarkeit des jeweiligen Potentiometerbereichs in Bezug auf das Getriebeelement zu ermöglichen.

Um die Schleiferträger mit der Leiterplatte drehbar zu verbinden sind diese mit Hilfe einer Dreh-Schnappvebindung in der Leiterplatte gelagert. Um eine optimale Lage des Schleiferträgers in Bezug auf das Getriebeelement, mit dem es in Eingriff ist, zu erreichen, die zudem ausreichend stabil ist, sind an der Leiterplatte zusätzliche Führungen vorgesehen, die eine kippsichere Lagerung gewährleisten.

Eine einfache Kontaktierung der Leiterplatte wird durch den Kontaktbereich ermöglicht, der als Bestandteil der Leiterplatte durch einfaches Aufstecken auf eine Steckverbindung des Antriebsgehäuses mit dem mindestens einen Antriebsmotor verbindbar ist.

Bei bestimmten Ausführungen kann es sinnvoll sein auch den oder die Antriebsmotore elektrisch und mechanisch mit der Leiterplatte zu verbinden. Dadurch ist es nicht erforderlich zusätzliche Maßnahmen für die Kontaktierung der Motoren im Antriebsgehäuse vorzusehen.

Eine sichere Kontaktierung wird dabei dadurch erreicht, daß die Kontaktstellen des Kontaktbereichs aus je zwei oder vier einander gegenübeliegenden zungenförmigen Kontakten bestehen, in die korrespondierende Gegenkontakte aus flachen Kontaktfahnen oder Kontaktstiften bestehen, deren Dicke größer ist als ein Freiraum zwischen den zungenförmigen Kontakten. Beim Einstecken verhaken sich diese zungenförmigen Kontakte in den Kontaktfahnen bzw. Kontaktstiften und halten die Verbindung sicher aufrecht. Eine noch geringere Bauteileanzahl ist möglich, wenn das Antriebsgehäuse einstückig mit er Leiterplatte ist.

Die Aufgabe der Erfindung wird durch folgendes Verfahren gelöst:
- Stanzen eines Leitblechs mit Leiterbahnen, wobei hilfsweise ein Halterahmen und/oder Haltestege belassen werden um die Leiterbahnen zu halten;
- Umspritzen von Teilen des Leitblechs mit Kunststoffmaterial;
- Bedrucken der Leiterplatte mit Widerstandsbahnen;
- Aushärten der Widerstandsbahnen;
- Entfernen des Halterahmens und/oder der Haltestege;
- Biegen der Leiterplatte;

Durch dieses Verfahren kann die Herstellung der Potentiometer in üblicher Weise erfolgen, weil die Hauptbestandteile der Leiterplatte zunächst in einer Ebene angeordnet sind. Auch das Stanzen des Leitblechs, das Umspritzen und das Entfernen des Halterahmens lassen sich einfacher ausführen, solange die Leiterplatte noch nicht gebogen ist. Durch das Biegen wird die spezielle Form erreicht, die der jeweilige Einsatzfall erfordert. Natürlich sind auch Anwendungsfälle denkbar bei denen auf das Biegen verzichtet werden kann.

Nachfolgend wird anhand der Zeichnung ein Ausführungsbeispiel der Erfindung näher erläutert.

Es zeigen
Fig. 1a eine Schnittansicht eines erfindungsgemäßen Stellantriebs,
Fig. 1b einen vergrößerten Ausschnitt aus Fig. 1a,
Fig. 2a eine Schnittansicht einer Leiterplatte,
Fig. 2b einen Teil einer Draufsicht (Z) auf Fig. 2a,
Fig. 3 eine Draufsicht auf eine ungebogenen Leiterplatte,
Fig. 4a eine Schnittansicht durch eine Kontaktstelle,
Fig. 4b eine Draufsicht auf eine erste Variante der Kontaktstelle und
Fig. 4c eine Draufsicht auf eine zweite Variante der Kontaktstelle.

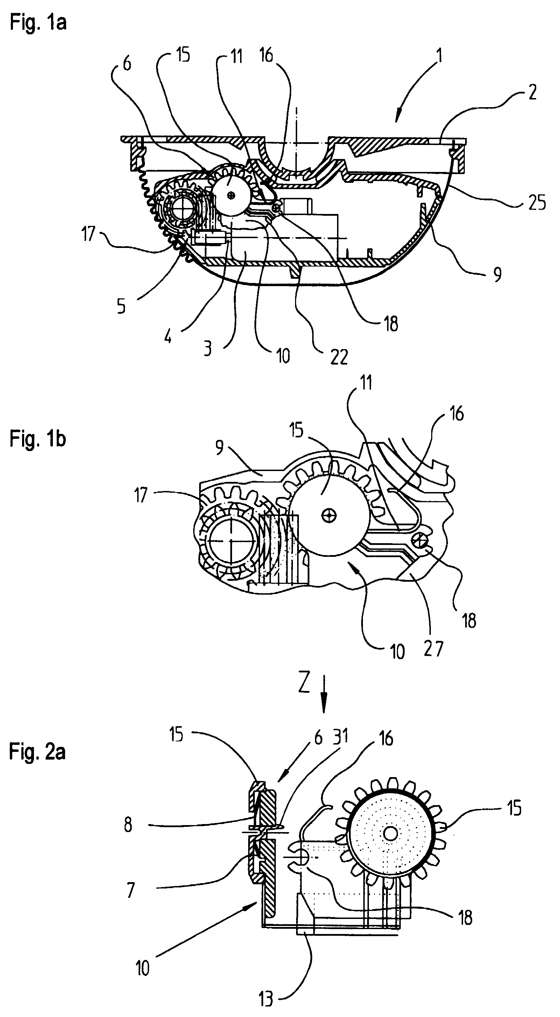

Fig. 1a zeigt eine Schnittansicht eines erfindungsgemäßen Stellantriebs 1, hier als Antrieb für einen Kfz-Rückblickspiegel ausgebildet, mit einem Stellglied 2, hier als Spiegelglasträger dargestellt, einem Antriebsgehäuse 9, in dem zwei Antriebsmotoren 3 (nur ein Antriebsmotor etc. sichtbar) form- oder kraftschlüssig aufgenommen sind, deren Ausgangswellen 4 mit je einem Untersetzungsgetriebe 5 getrieblich in Eingriff sind, deren Ausgangszahnräder mit je einem Verstellelement 25 getrieblich in Eingriff sind, das mit dem Stellglied 2 verbunden ist und einer Leiterplatte 10, die im Antriebsgehäuse 9 form- und/oder kraftschlüssig befestigt ist und zwei Schleiferträger 15, als erstes Teil eines Potentiometers 6, drehbar gelagert aufnimmt, die mit Widerstandsbahnen 7, als zweites Teil des Potentiometers 6 und/oder Leiterbahnen auf der Leiterplatte 10 zusammenwirken, wobei die Schleiferträger 15 in Form von Zahnrädern ausgebildet sind, von denen jedes mit einem Getriebeelement 17 je eines Untersetzungsgetriebes 5 getrieblich in Eingriff sind. Die Leiterplatte 10 ist über zwei Schnappverbindungen 18 zum Teil um die Schnappverbindungsstellen schwenkbar im Antriebgsgehäuse 9 gelagert. Die Leiterplatte 10 besteht im wesentlichen aus einem Leitblech 11, das Leiterbahnen 22, als elektrischen Verbindungen zwischen den Antriebsmotoren 3, den Widerstandsbahnen 7 und Anschlüssen innerhalb des Antriebsgehäuses 9 darstellt. Das Leitblech 11 weist zumindest einen federnden Bereich 16 auf, mit dessen Hilfe zumindest einer der Schleiferträger 15 spielfrei mit einem der Getriebeelemente 17 in Eingriff gehalten wird.

Fig. 1b zeigt vergrößert dargestellt, die Leiterplatte 10, mit der Schnappverbindung 18 im Antriebsgehäuse 9, dem Leitblech 11, dem Schleiferträger 15 und dem Getriebeelement 17. das Getriebeelement 17 ist vorzugsweise das Ausgangszahnrad bzw. läuft mit der selben Umfangsgeschwindigkeit, wie das Ausgangszahnrad, damit der Schleiferträger 15, der mit dem Getriebeelement 17 getrieblich in Eingriff ist ebenfalls ohne Unter- oder Übersetzung mit dem Stellglied synchron läuft. Im Antriebsgehäuse 9 sind Führungen 27 vorgesehen, in denen Teile der Leiterplatte 10 geführt werden können.

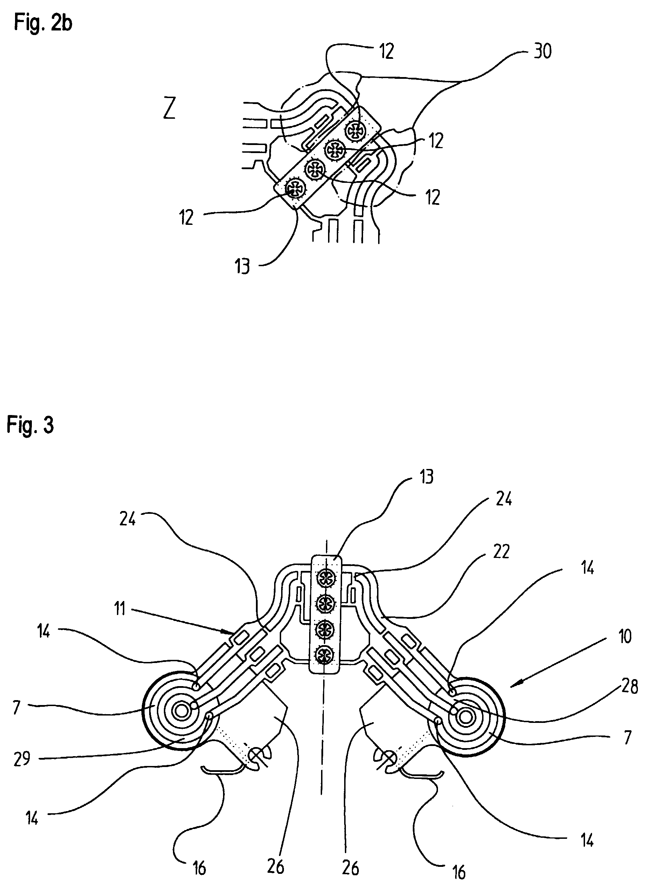

Fig. 2a zeigt die Leiterplatte 10 in abgewinkelter Form, so dass die beiden Schleiferträger 15 rechtwinklig zueinander angeordnet sind. Die Schleiferträger weisen Schleifer 8 auf, die mit den Widerstandsbahnen 7 und Leiterbahnen in elektrischen Kontakt stehen. Die Schleiferträger 15 sind in der Leiterplatte 10 durch eine Dreh-Schnappverbindung 31 drehbar gelagert. Die federnden Bereiche 16 sind vorzugsweise Teile des Leitblechs und halten jeweils einen Schleiferträger 15, wobei der Teil der Leiterplatte 10, die den Schleiferträger 15 trägt geringfügig um die Schnappverbindung 18 schwenkbar ist, bis der Getriebeeingriff zwischen dem Schleiferträger 15 und dem Getriebeelement 17 spielfrei ist. Das Leitblech 11 ist nur Teilweise mit Kunststoffmaterial umspritzt, die freiliegenden Teile des Leitblechs 11 können auch alleine eine ausreichende federnde Wirkung auf den Schleiferträger 15 ausüben. In Fig. 2b sind die beiden federnden Bereiche 30 gekennzeichnet. Zwischen den beiden federnden Bereichen 30 ist ein Kontaktbereich 13 ausgebildet, der teilweise durch Kunststoffmaterial umspritzt ist. Der Kontaktbereich 13 weist Kontaktstellen 12 auf, die so geformt sind, dass sie auf Kontaktstifte gesteckt werden können, dann aber eine Rückhaltewirkung besitzten.

Fig. 3 zeigt eine ungebogene Leiterplatte 10, mit dem Leitblech 11, dessen einzelne Leiterbahnen über Haltestege 24 miteinander verbunden sind, die nach dem Umspritzen des Leitblechs 11 unterbrochen oder ausgestanzt werden. Die Enden 14 der Widerstandsbahnen 7 sind mit den Leiterbahnen 22 elektrisch verbunden. Die federnden Bereiche 16 am Leitblech 11 können entfallen, wenn die federnden Bereiche 30 eine ausreichende federnde Wirkung aufweisen. Damit die Leiterplatte 10 und damit die Schleiferträger 15 in Bezug auf das Getriebeelement 17 ausgerichtet bleibt, sind Führungsbereiche 26 an der Leiterplatte 10 vorgesehen, die in entsprechenden Führungen 27 am Antriebsgehäuse 9 aufgenommen werden können. Vorzugsweise sind die Führungen 27 am Antriebsgehäuse 9 so ausgeführt, dass sie die Leiterplatte 10 beidseitig führen.

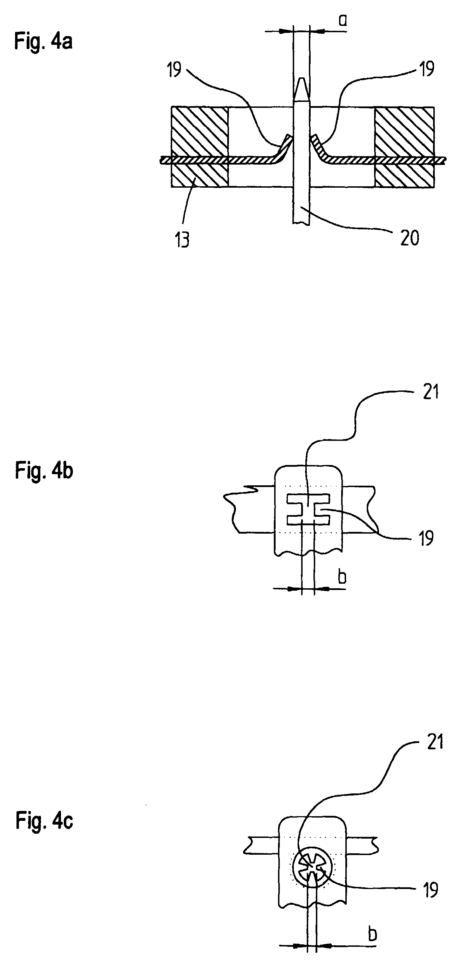

Fig. 4a zeigt den Kontaktbereich 13 im Schnitt, mit zungenförmigen Kontakten 19, in die ein stiftartiger Gegenkontakt 20 eingesteckt ist. In Fig. 4b ist eine Draufsicht auf eine erste Variante einer Kontaktstelle dargestellt, mit den zungenförmigen Kontakten 19, die durch einen Freiraum 21 mit der Breite b voneinander getrennt sind. Die Breite b ist geringer als der Durchmesser a des Gegenkontakts 20. Fig. 4c zeigt eine zweite Variante einer Kontaktstelle, wobei vier zungenförmige Kontakte 19 vorgesehen sind.

### Bezugszeichenliste

- 1: Stellantrieb
- 2: Stellglied
- 3: Antriebsmotor
- 4: Ausgangswelle (Antriebsmotor)
- 5: Untersetzungsgetriebe
- 6: Potentiometer
- 7: Widerstandsbahnen
- 8: Schleifer
- 9: Antriebsgehäuse
- 10: Leiterplatte
- 11: Leitblech
- 12: Kontaktstellen
- 13: Kontaktbereich
- 14: Enden der Widerstandsbahn
- 15: Schleiferträger
- 16: federnde Bereiche (am Leitblech)
- 17: Getriebeelement
- 18: Schnappverbindung
- 19: Kontakte (zungenförmige)
- 20: Gegenkontakte (flache Kontaktstifte)
- 21: Freiraum
- 22: Leiterbahnen
- 24: Haltestege
- 25: Verstellelement
- 26: Führungsbereich (Leiterplatte)
- 27: Führungen (Antriebsgehäuse)
- 28: Potentiometerbereich
- 29: Potentiometerbereich
- 30: federnder Bereich
- 31: Dreh-Schnappverbindung

## Patentansprüche

1. Stellantrieb (1) zum Verstellen eines Stellglieds (2) in zumindest zwei Freiheitsgraden, mit mindestens einem Antriebsmotor (3), dessen Ausgangswelle (4) getrieblich mit einem das Stellglied (2) antreibenden Untersetzungsgetriebe (5) verbunden ist, zwei, die Ist-Stellung des Stellglieds (2) erfassenden, auf einer Leiterplatte (10) angeordneten Potentiometern (6) mit Widerstandsbahnen (7) und Schleifern (8) und einem Antriebsgehäuse (9), **dadurch gekennzeichnet,** dass die Leiterplatte (10) aus einem zumindest teilweise in Kunststoffmaterial eingebetteten Leitblech (11) besteht, das die Enden der einzelnen Widerstandsbahnen (7) elektrisch mit Kontaktstellen (12) verbindet, die Widerstandsbahnen (7) zwischen ihren Enden (14) vom Kunststoffmaterial getragen werden, die Schleifer (8) auf Schleiferträgern (15) befestigt sind, die in Form von Zahnrädern, Reibrädern oder Kurbelscheiben ausgebildet, drehbar in der Leiterplatte (10) gelagert und getrieblich mit dem Untersetzungsgetriebe (5) und/oder dem Stellglied (2) verbunden sind und daß die Leiterplatte (10) an zumindest einer Stelle abgewinkelt ist, wodurch die Widerstandsbahnen (7) der beiden Potentiometer (6) in unterschiedlichen Ebenen angeordnet sind und die Leiterplatte mit den Potentiometern (6) und den Kontaktstellen eine Baugruppe bilden, wobei die beiden Potentiometer (6) der Baugruppe (10) zueinander nicht starr angeordnet sind.

2. Stellantrieb nach Anspruch 1, **dadurch gekennzeichnet,** dass das Kunststoffmaterial der Leiterplatte (10) mit Befestigungsmitteln zur Befestigung der Leiterplatte (10) in dem Antriebsgehäuse (9) einstückig ist.

3. Stellantrieb nach Anspruch 1 oder 2, **dadurch gekennzeichnet,** dass die Leiterplatte (10) im Antriebsgehäuse (9) einrastbar ausgebildet ist.

4. Stellantrieb nach Anspruch 1, 2 oder 3, **dadurch gekennzeichnet,** dass zumindest ein Teil der Leiterplatte (10) im Antriebsgehäuse (9) begrenzt kippbar ist.

5. Stellantrieb nach Anspruch 1, 2, 3 oder 4, **dadurch gekennzeichnet**, dass die Leiterplatte (10) im Antriebsgehäuse (9) geführt ist.

6. Stellantrieb nach Anspruch 5, **dadurch gekennzeichnet,** dass Führungen (27) rechtwinklig zur Achse von Getriebeelementen (17) angeordnet sind, die unmittelbar mit Schleiferträgem (15) der Potentiometer (6) gekoppelt sind.

7. Stellantrieb nach Anspruch 1, 2, 3, 4, 5 oder 6, **dadurch gekennzeichnet,** dass das Leitblech (11) mit federnden Bereichen (16, 30) einstückig ist, die Spielfreiheit zwischen dem Schleiferträger (15) und einem Getriebeelement (17) herstellen.

8. Stellantrieb nach Anspruch 7, **dadurch gekennzeichnet,** dass die Leiterplatte in drei Bereiche unterteilt ist, einen Kontaktbereich (13) und zwei Potentiometerbereiche (28, 29), der Kontaktbereich (13) jeweils über mehrere Leiterbahnen (22) des Leitblechs einerseits mit dem Potentiometerbereich (28) und andererseits mit dem Potentiometerbereich (29) verbunden ist, wobei die Leiterbahnen (22) die federnden Bereiche (16, 30) bilden.

9. Stellantrieb nach Anspruch 8, **dadurch gekennzeichnet,** dass die Potentiometerbereiche (28, 29) mit Führungsbereichen (26) versehen sind, die kippsicher in den Führungen (27) geführt sind.

10. Stellantrieb nach Anspruch 1, 2, 3, 4, 5, 6, 7, 8 oder 9, **dadurch gekennzeichnet,** dass jeder Potentiometerbereich (28, 29) mit einem Gelenkteil, als Teil einer Schnappverbindung (18) versehen ist, das in ein komplementäres Gelenkteil des Antriebsgehäuses (9) einschnappbar ist.

11. Stellantrieb nach Anspruch 10, **dadurch gekennzeichnet,** dass mindestens eine mögliche Schwenkachse jeder Schnappverbindung (18) parallel zur Drehachse des korrespondierenden Getriebeelements (17) verläuft.

12. Stellantrieb nach Anspruch 1, 2, 3, 4, 5, 6, 7, 8, 9 oder 10, **dadurch gekennzeichnet,** dass die Schleiferträger (15) mit Hilfe von Dreh-Schnappverbindungen (31) in der Leiterplatte (10) drehbar und kippsicher gelagert sind.

13. Stellantrieb nach zumindest einem der vorhergehenden Ansprüche, **dadurch gekennzeichnet,** dass die Schleiferträger (15) mit Hilfe der an der Leiterplatte (10) und am Antriebsgehäuse (9) vorgesehenen Führungen (26, 27) kippsicher geführt sind.

14. Stellantrieb nach zumindest einem der vorhergehenden Ansprüche, **dadurch gekennzeichnet,** dass zumindest ein Antriebsmotor (3) elektrisch und mechanisch mit der Leiterplatte (10) verbunden ist.

15. Stellantrieb nach zumindest einem der vorhergehenden Ansprüche, **dadurch gekennzeichnet,** daß die Leiterplatte (10) über den Kontaktbereich (13) elektrisch mit Leitern im oder am Antriebsgehäuse (9) elektrisch verbunden ist.

16. Stellantrieb nach Anspruch 15, **dadurch gekennzeichnet**, daß die Kontaktstellen (12) des Kontaktbereichs (13) aus je zwei oder vier einander gegenüberliegenden zungenförmigen Kontakten (19) bestehen, in die korrespondierende Gegenkontakte (20) aus flachen Kontaktfahnen oder Kontaktstiften, deren Dicke größer ist als ein Freiraum (21) zwischen den zungenförmigen Kontakten (19), einsteckbar sind.

17. Stellantrieb nach zumindest einem der vorhergehendne Ansprüche, **dadurch gekennzeichnet,** daß das Antriebsgehäuse (9) einstückig mit der Leiterplatte (10) ist.

18. Verfahren zur Herstellung einer Leiterplatte (10) für einen Stellantrieb (1), **gekennzeichnet durch** folgende Verfahrensschritte:
a) Stanzen eines Leitblechs (11) mit Leiterbahnen (22), wobei hilfsweise ein Halterahmen und/oder Haltestege (24) belassen werden um die Leiterbahnen (22) zu halten;
b) Umspritzen von Teilen des Leitblechs (11) mit Kunststoffmaterial;
c) Bedrucken der Leiterplatte (10) mit Widerstandsbahnen (7);
d) Aushärten der Widerstandsbahnen (7);
e) Entfernen des Halterahmens und/oder der Haltestege (24);
f) Biegen der Leiterplatte (10);
